# EUROPEAN PATENT APPLICATION

(11) **EP 2 731 060 A2**
(43) Date of publication of application: **14.05.2014**
(21) Application number: 13191865.8
(22) Date of filing: 07.11.2013
(51) Int. Cl.: G06K 19/077, H01F 41/06

(54) **Method and device for winding a coil and attaching the same to a substrate**

(30) Priority: 08.11.2012 EP 12191870
(71) Applicant: Finlay, Garreth, Ballymote, Co. Sligo (IE); Hynes, Fergus, Strandhill, Co. Sligo (IE)
(72) Inventor: Finlay, Garreth, Ballymote, Co. Sligo (IE); Hynes, Fergus, Strandhill, Co. Sligo (IE)
(74) Representative: Misselhorn, Hein-Martin

(57) **Abstract**

Method for producing RFID cards with a coil and an RFID chip in which the coil, using a winding device, is first wound as a substrate-less coil, which after the completion of the winding process is held at the end face of a winding plate, whereupon the winding plate is placed against the first side of a substrate with the end face on which it holds the wire wound into a coil, **characterized in that** a vibrating die is placed against the second opposite side of the substrate which transmits such ultrasound vibrations through the substrate into the area of the wire of the coil wedged between the winding plate, which acts as an anvil, and the first substrate surface, that it is embedded at least partially into the substrate surface.

## Description

The invention relates to a method for laying a wire conductor on a card substrate and for contacting the wire conductor to a chip attached to the substrate. The invention moreover relates to a device for carrying out such a method.

Typically, RFID cards are produced by means of such a method and such a device. In the case of cards of this type, in the end a chip is attached to the card substrate.

Various types of methods are known for producing such RFID cards. A first type of method can be characterized, in a key word, as a "direct laying method".

For a process of this type it is characteristic that the front end of a wire conductor is connected in an electrically conductive manner to the first contact surface of the chip. Subsequently, the wire conductor is laid on the surface so as to form a coil. Once this has been done, the tail end of the wire conductor is connected to a second contact surface of the chip.

This generic method is known from the European patent EP 0 880 754. This patent describes the following procedure:
In order to lay the wire conductor on the card substrate, a wire laying pin is used which guides the wire conductor in relation to the substrate. The wire conductor is embedded into the surface of the card substrate by means of an ultrasound vibration device which applies ultrasound vibrations to the wire laying pin that act perpendicularly to the substrate surface of the card substrate and which embed the wire conductor in the card substrate.

The difficulty in such a process lies in properly connecting the wire conductor to the terminal areas of the chip. This is difficult because the wire conductors used are very fine, and the chips highly miniaturized, so that they only have correspondingly small contact surfaces.

The known patent proposes to solve this problem by the chip first being mounted on the substrate. Then, the wire is embedded into the surface of the substrate on the one side of the chip and brought up to the chip in this manner. Now, the process of embedding the wire conductor is interrupted and the wire conductor is guided over the chip so as to come to rest on the terminal area of the chip. Starting from the point at which the chip has crossed the wire conductor, it is again embedded into the substrate at least locally. In this way, the wire conductor is fixed relative to the chip in such a manner that it already assumes its correct position on the contact surface of the chip and is incapable of being removed from this position. In order to produce a reliable electrically conductive connection between the wire conductor and the contact surface of the chip, a welding die now only has to be pressed onto the already properly positioned wire conductor. This can then weld the wire conductor to the contact surface by means of a so called "Thermode" without measures having to be taken at this stage to ensure the correct positioning of the wire conductor.

The procedure can be used both for connecting in an electrically conductive manner the front end of the wire conductor to the contact surface of the chip as well as connecting in an electrically conductive manner the tail end of the wire conductor, subsequent to it being laid as a coil, to the second contact surface of the chip.

If the chip is to be mounted onto the substrate not right away, but only after laying the wire conductor as a coil, the known patent makes an alternative proposal. In that case, a window is to be punched into the substrate. The chip is later inserted into the window with an exact fit. The front end and the tail end of the wire are to be drawn over this window in such a way that both the front end as well as the tail end of the respective wire conductor are attached to the substrate on both sides of the window. In this way, the wire conductor is fixed to the substrate in such a manner, both at its front end as well as at its tail end, that, later, when the chip is inserted into the window, it comes to lie correctly on the contact surfaces of the chip without any problems. Also in this case, the welding die only has to be pressed onto the wire conductor in order to weld it to the contact surfaces. It does not have to be ensured anymore that the wire really is properly positioned, for it is attached to the substrate in the exact position.

The above-described method is disadvantageous in that it is relatively time-consuming. This is the case because the wire conductor has to be connected to the substrate on both sides of the chip or of the window provided for accommodating the chip, in order to provide the conditions for contacting.

The other known type of method can be referred to, in key words, as "external coil-winding with subsequent baking, pressing or laminating".

A coil is first wound in this method using a corresponding winding unit, the coil is thereafter connected to a chip and then bonded to a substrate by baking, pressed into a substrate surface with a correspondingly large pressure, or bonded to the substrate by laminating it in.

This manner of uniting the coil and the chip connected thereto is either not very gentle (baking, pressing) or entails considerable effort (laminating the loose coil with the chip attached thereto).

In contrast to this, it is the object of the invention to propose a more efficient and gentler method for producing an RFID unit attached to a substrate.

This object is accomplished with the features of claim 1.

According to the invention, the method for producing RFID cards with a coil and an RFID chip is carried out by first winding a substrate-less coil using a winding device.

In a next method step, the chip is preferably connected in an electrically conductive manner to the ends of the coil wire, with the positioning aid offered by the winding device or its winding plated being utilized.

After the winding procedure has been completed, the substrate-less coil is held at the end face of a winding plate. Then, the winding plate is placed against the first side of a substrate with the end face on which it holds the wire wound into a coil. At the same time, or at least in an immediately subsequent method step, a vibrating die is placed against the second opposite side of the substrate. The die transmits such ultrasound vibrations through the substrate into the area of the wire of the coil wedged between the winding plate, which acts as an anvil, and the first substrate surface, that it is embedded at least partially into the substrate surface.

Therefore, the method according to the invention is a hybrid solution which "extracts" from the different methods that are already known their respective particularly advantageous method steps and combines them in a totally novel process sequence which exhibits the strong points of each of the known methods, but not their weak points.

Winding the coil separately from the substrate to be combined with it later, while using a winding unit, i.e. a tool that determines the shape of the coil precisely, is exceptionally fast and ensures a consistent quality and precision of the coils wound in this manner. Such a winding of the coils is particularly advantageous if the opportunity is taken at the same time to connect the chip in an electrically conductive manner to the ends of the wire forming the coil while the coil is still held on the winding plate. For the ends of the coil wire can be precisely positioned while the wire is inserted into the winding unit, and the winding unit can comprise a window or the like, which the ends of the wires forming the coil span and which precisely determines the proper position for the chip when it is inserted, so that it its contact surfaces exactly coincide with the wires to be connected thereto.

The attachment to the substrate of the coil and optionally of the chip connected with it by embedding the wire into the substrate using ultrasound vibrations is gentle and particularly quick in the case of the process sequence defined according to the invention. Because due to the fact that the coil is already wound, the vibrating die no longer has to trace every winding of the coil but only has to trace the circumference of the coil once because the previously wound coil constitutes a wire bundle consisting of several wires lying close to each other, which are embedded into the surface of the substrate together under the influence of the ultrasound vibrations of the vibrating die.

Another essential aspect of the invention deals with the issue of how it is possible to produce coils with different diameters or sizes using a single tool.

The production of different wire patterns by clamping the wire onto a winding plate is well-known. Diverting pins, around which the wire is spanned, protrude from such a winding plate in those places where the wire is supposed to change its direction.

A separate winding plate is require for each new wire pattern, which requires a corresponding tooling expenditure.

It is an object of the invention to propose a simpler option of winding different wire patterns, and particularly of winding coils of different sizes, i.e. coils that include a larger or smaller cross section.

According to the invention, this object is achieved by a coil winding machine, or coil winding and wire laying machine, comprising a system consisting of a winding plate and diverting inserts inserted into the winding plate from which diverting organs project which protrude over the surface of the winding plate. The wire is wound around these diverting organs into a preferably rectangular coil. In this case, the winding plate is configured in such a manner that the position of the diverting organs relative to the winding plate can be changed in such a way that coils can be wound with, in principle, the same course of the wire but different clear diameters.

Further mechanisms of action, advantages and optional embodiments of the invention become apparent from the following description of the specific exemplary embodiments with reference to the Figures. In the Figures:
Fig. 1 shows the winding unit 1 in its entirety, in a closed form.
Fig. 2 shows a top view onto the winding plate 2 forming the top part of the winding unit 1, seen from the side of the winding groove 18, at a moment in time in which the front end of the wire forming the coil is fixed to the winding plate 2 prior to winding a new coil.
Fig. 3 shows a top view onto the winding plate 2 forming the top part of the winding unit 1, seen from the side of the winding groove 18, but at a moment in time in which the tail end of the wire forming the coil is fixed to the winding plate 2 subsequent to winding a new coil.
Fig. 4 shows the winding plate and coil already shown in Figs. 2 and 3 at that moment in time in which the ends of the coil wire spanned over the chip accommodating window are stripped using a solder jet 27.
Fig. 5 shows the winding plate and coil already shown in Figs. 2 to 4 at that moment in time in which the RFID chip has been connected to the ends of the coil wire in an electrically conductive manner.
Fig. 6 shows the process of embedding the coil into a substrate using the winding plate which turns the anvil.
Figs. 7a to 7d show different diverting inserts, each of which, together with winding plates having different adapted accommodating openings 22, forms a system for producing different coils.
Fig. 7e shows a family of coils or a series of three coils 28 to 28", each with different diameters.
Fig. 8 shows a second exemplary embodiment of a winding plate 2 which deviates from the Figs. 1 to 5 with respect to its accommodating openings.
Fig. 9 shows a third exemplary embodiment of a winding plate 2 which deviates from the Figs. 1 to 8.
Figs. 10a and 10b show examples of different diverting inserts 14 which, together with the winding plate according to Fig. 9, form a system for producing different coils.
Fig. 11 shows a pretreatment device for stripping and tin-plating of the wire ends in situ on the winding plate 2.
Fig. 12 shows an alternative of stripping and tin-plating the wire prior to it being fed into the wire guide 12.
Figs. 13 and 14 illustrate the function of the solder jet.

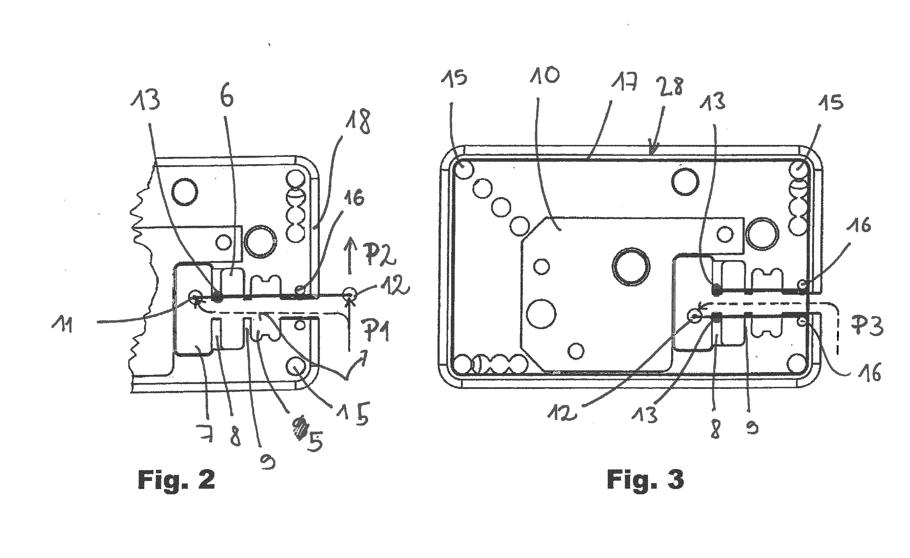

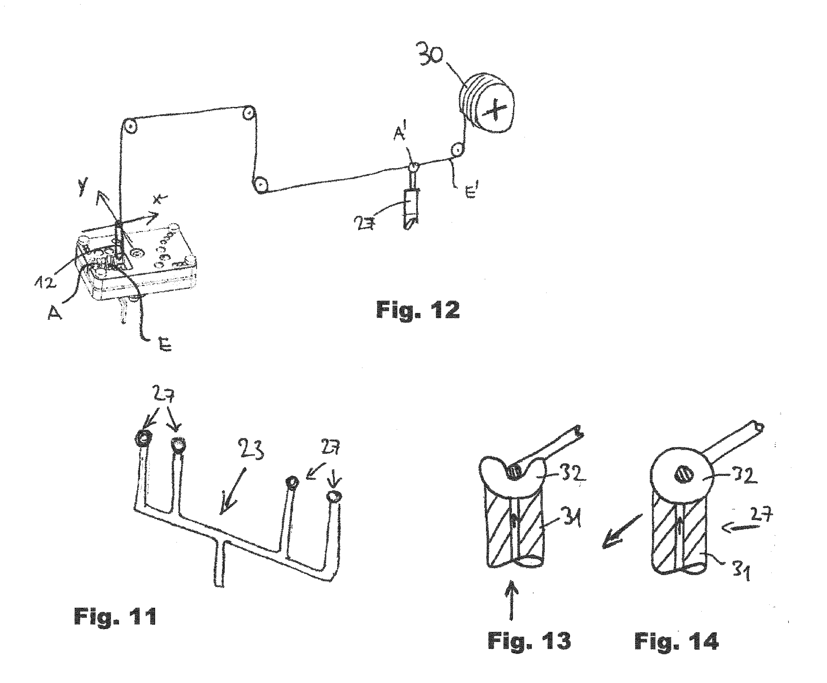

Fig. 12 again shows the exemplary embodiment already shown by Figs. 2 and 3 of the winding plate, after the completion of the wire winding process, at that stage at which the RFID chip is connected to the ends of the wire in an electrically conductive manner.
Fig. 13 shows a family of coils of different sizes as they can be produced very efficiently using the system according to the invention, which consists of the above-described winding plate 2 and the diverting inserts 14 associated therewith, which are replaceable or can be positioned variably.
Fig. 14 shows the process of embedding the coil into the substrate using the winding plate as an anvil and using the vibrating die which applies ultrasound vibrations to the wire through the substrate.

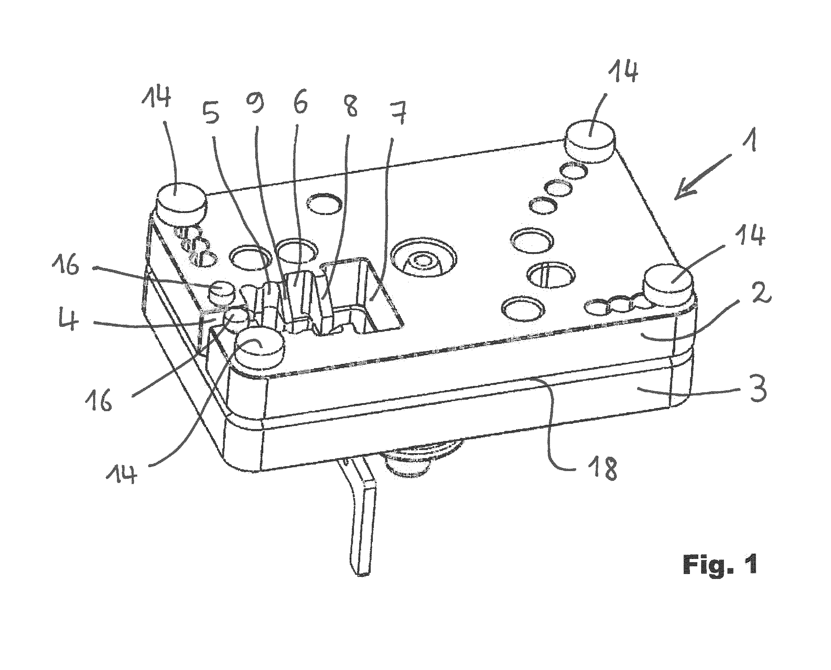

Fig. 1 shows a winding unit 1 according to the invention in its assembled state.

This winding unit 1 consists of the winding plate 2, which here functions as the top part, and of the bottom part 3.

The winding plate 2 comprises a wire feeding channel 4 which connects the chip accommodating window 5, the middle window 6 and the wire guide window 7 with each other. In this case, the wire guide window 7 is delimited by first webs 8 from the middle window 6. In turn, the middle window 6 is delimited by the second webs 9 from the chip accommodating window 5.

The winding plate 2 and the bottom part 3 of the winding unit 1 do not rest against each other directly, but with a spacer 10 placed between them. According to Fig. 2, the latter preferably has the form of a plastic or metal sheet which ideally is thicker by approx. 10 to 30% than the diameter of a single wire 17 of which the coil later consists. Because the spacer 10 does not completely reach the edge of the end face of the winding plate 2 facing towards it, the winding unit 2 and the bottom part 3 associated therewith form a winding groove 18 which is preferably closed in itself in the circumferential direction, i.e. a gap into which one or preferably several layers of wire can be inserted in order to wind the wire into a coil.

At the start of each winding process, the front end of the wire 17 which is to be wound into a coil in the next step has to be attached to the winding unit 1.

Fig. 2 shows how this attachment takes place.

Basically, the wire 17, during the attachment of the wire ends and during the winding of the coil, is supplied via a wire guide 12, which is a tube. The wire can be fed via this central bore hole for opening the tube and exit in the area of the stylus tip.

At the beginning of each new winding process, the free end of the wire protruding from the wire guide 12 is held taut between the wire guide 12 and a wire gripper 11. The wire gripper 11 and the wire guide 12 are moved synchronously at that stage so that the wire 17 is held taut between them.

Keeping this in mind, it is understood what is illustrated in Fig. 2 with the arrow P1 - there, the wire gripper 11 is moved through the wire feeding channel 4 in the direction of the arrow P1 into the wire guide window 7. Having reached that location, the wire gripper is moved in such an oblique manner to the longitudinal axis of the wire feeding channel 4 that the wire 17 which is still taut between the wire gripper 11 and the wire guide 12 is brought into the position shown by Fig. 2 in which it spans over the projections 8, 9 and the chip accommodating window 5. Once the wire 17 has been brought into this position, it is pressed by a wire clamp 13, which in this case is merely indicated by a black dot, against the respective first web 8. Thus, the wire 17 is clamped between the first web 8 and the wire clamp 13. Now, the wire gripper 11 can release the free wire end, whereupon the wire gripper 11 is retracted.

Now, the wire guide 12 begins circling the winding unit 1 in the direction of the arrow P2. At the exit of the wire feeding channel, the wire 17 is laid around the diverting pin 16 in order to then be inserted into the winding groove 18. Once it has reached an outer corner of the winding plate, it is diverted by a diverting organ 14 to be described later in order to then be inserted into the winding groove 18, which runs along the subsequent side of the winding plate. The wire guide 12 now circles the winding unit until the required number of coil windings are inserted into the winding groove 18 running around the winding unit.

Towards the end of the winding process, the wire guide 12 moves along the arrow P3, i.e. it lays the wire around the second one of the diverting pins 16 and, coming from the outside, moves it into the wire feeding channel 4 and crosses the latter until it reaches the wire guide window 7, which serves as its run-out area. There, the wire guide 12 executes a slight transverse movement, oblique to the longitudinal axis of the wire feeding channel 4. In this manner, it brings the end of the wire 17 into the position shown by Fig. 3, so that the wire 17 is spanned over the other one of the two first webs 8 and also the other one of the two second webs 9.

Now, a wire clamp 13 again comes into action which in this case is again only indicated as a black dot. This wire clamp 13 clamps the wire on the first web 8, such as is also shown by Fig. 3.

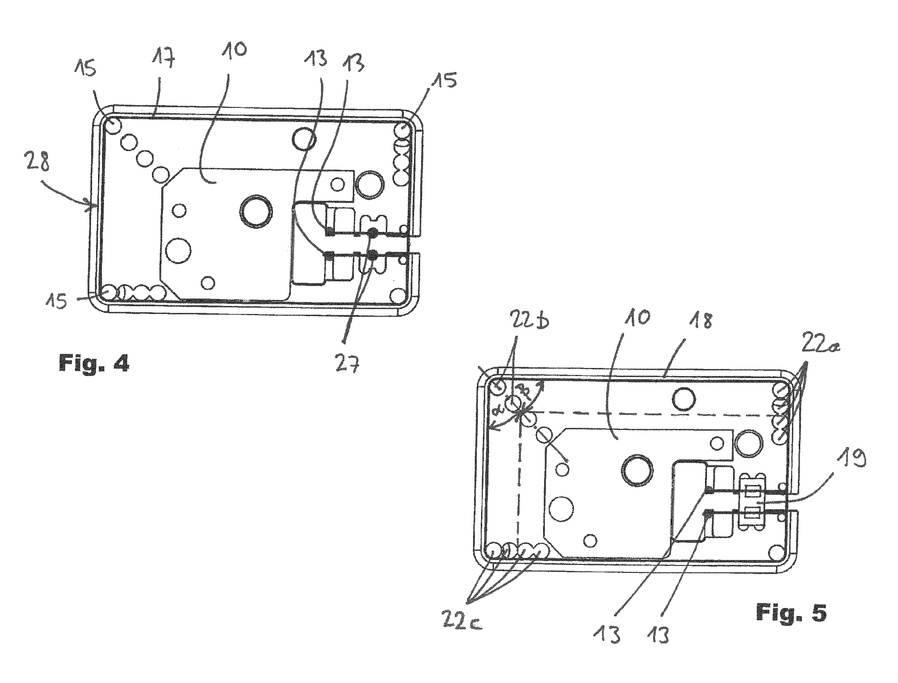

The result of all of these actions is a finished, wound coil as it is shown by Fig. 4.

After the winding of the coil has been completed, the coil ends are connected to the contact surfaces of the associated RFID chip, preferably while the coil is still held by the winding plate 2.

Soldering is a conventional connecting technique. When using RFID chips which are to be conventionally connected by soldering, the process is therefore the following:
A solder jet 27 as it will be described later is brought from the outside towards the wire ends that are held taut over the chip accommodating window 5, see Fig. 4. The hot solder first causes the insulation of the wires to burn off locally and then, when the wire has become hot enough, the wire to be coated with the thin tin layer. The wire is now ready for soldering.

Then, a chip is brought up from the side of the chip accommodating window 5 facing away from the winding groove 18, which is accommodated by the chip accommodating window 5 with an exact fit so that the ends of the wire of the coil held taut over the chip accommodating window 5 extend over the terminal areas of the RFID chip. Then, the soldering process takes place from the other side of the chip accommodating window 5, which is also open. Fig. 5 shows the result of this process.

The procedure can be the same, mutatis mutandis, if no conventional soldering is done but if a welding or bonding process is carried out.

In this case, an alternative connecting technique consists of connecting the ends of the wire of the coil held taut over the chip accommodating window 5 with the contact surfaces of the RFID chip using an electrically conductive adhesive agent.

At the latest after the completion of the electrically conductive connection between the RFID chip and the wire forming the ends of the coil, the bottom part 3 is removed from the winding unit 1 so that the finished unit consisting of the coil and the RFID chip is exposed on the surface of the winding plate 2 in the way shown by Fig. 12.

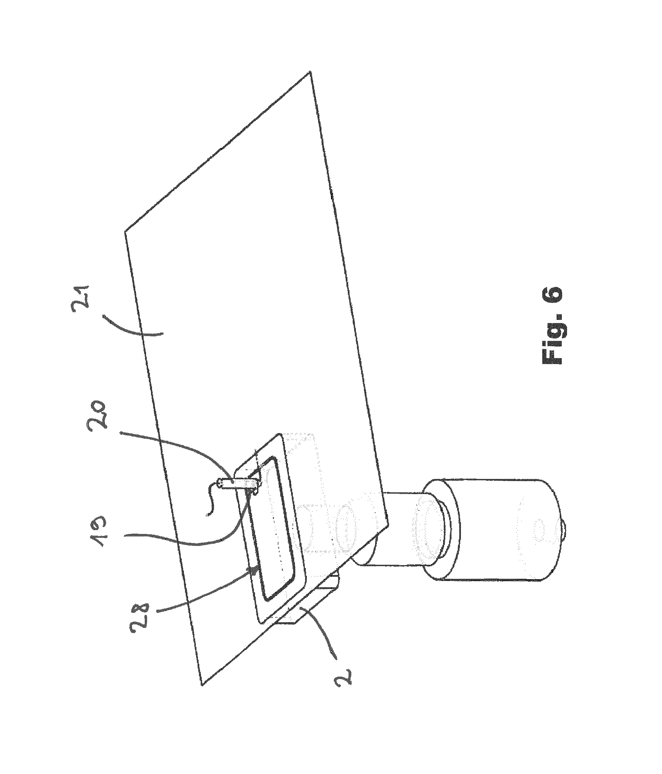

Using a suitable handling system, in the simplest case using an arm of a universally usable assembly robot, the winding plate 2 is gripped from the rear thereof facing away from the winding groove and, together with the arrangement consisting of the RFID chip and the coil held by it, is put up against a first side of a substrate in the way illustrated by Fig. 6. The substrate preferably is a thermoplastic material; it can, however, also be another substrate provided with a coating into which the wire can be embedded in the manner described below.

A vibrating die 20 is put up against the substrate surface from the second opposite side of the substrate. Vibrations whose amplitude is substantially oriented perpendicularly to the surface of the substrate are applied to the vibrating die 20 by a corresponding ultrasound generator. The vibrating die 20 transmits the ultrasound vibrations through the substrate 21 into the area of the wire wedged between the winding plate 2, which acts as an anvil, and the first surface of the substrate, in such a way that the wire is embedded at least partially into the coil surface. Preferably, the wire is even embedded substantially completely. Such an embedding process occurs because the ultrasound vibrations lead to microscopic relative movements between the wire and the substrate surface, whereby the wire heats up and then sinks into the thermoplastic surface because it locally softens the material of the surface. For the sake of completeness, it should be noted that the amplitude of the ultrasound vibrations does not exclusively have to extend perpendicularly to the substrate surface. Rather, it may also comprise, at least intermittently, a component oriented parallel to the substrate surface provided this is not so large that the wire is no longer embedded properly.

The diverting inserts which were already addressed above have yet to be described in more detail.

Very frequently, the need arises for being able to produce an entire family of coils with one and the same tool, i.e. coils that have the same basic design but which are larger or smaller by enclosing larger or smaller surfaces.

Fig. 6 shows such a series of coils.

The invention now permits the fabrication of such series of coils with different diameters using one and the same winding unit without having to modify the winding unit in an form, i.e. to have to interfere with the substance of the winding unit.

The diverting inserts 14 according to the invention are preferably provided at the outer corners of the winding plate 2 and of the bottom part 3 of the winding unit 1. As a rule, the diverting inserts 14 are inserted into the winding plate 2 from the side thereof facing away from the winding groove 18. These diverting inserts 14 each comprise a diverting organ 15 which protrudes over the surface of the winding plate facing towards the winding groove 18 and serves for diverting the wire 17 inserted into the winding groove 18 on a corner of the winding plate 2, preferably in such a way that the wire 17, which so far extended parallel to a side surface of the winding plate, extends parallel to the subsequent side surface of the winding plate 2 after passing the diverting organ.

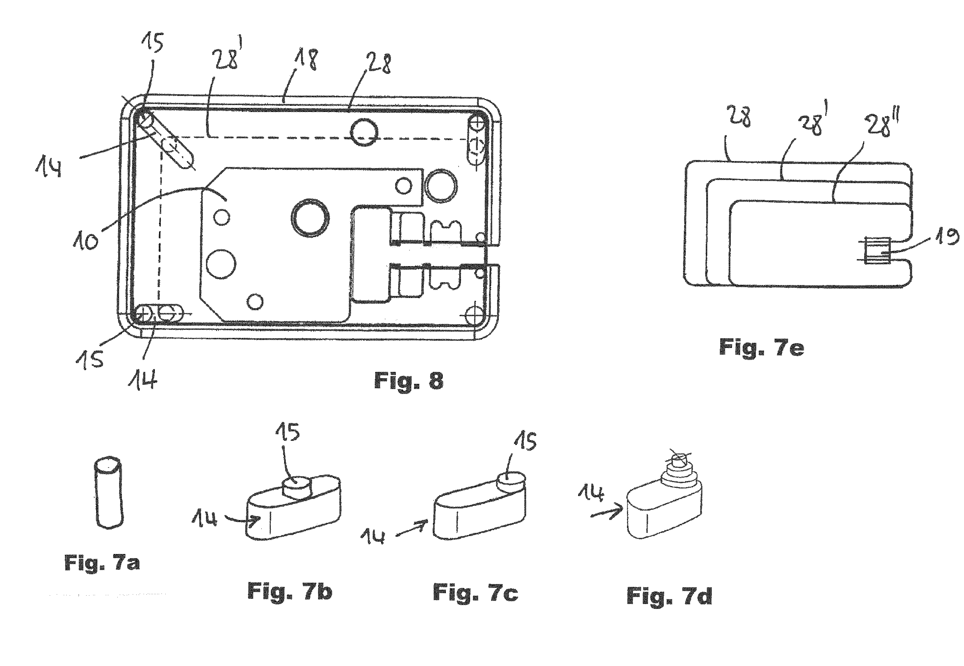

The simplest embodiment of such an diverting insert is a cylindrical pin in accordance with Fig. 7a which, apart from its possibly provided head which limits its plug-in depth, has a smooth jacket surface with a constant cross section, wherein a part of this jacket surface forms the diverting organ which is visually indistinguishable from the rest of the diverting insert.

In the simplest case the position of the diverting inserts can be adjusted due to the capability of the winding plate 2 to be equipped with diverting organs 2 in different places. For this purpose, the winding plate 2 comprises, in the area of each of its corners, several differently positioned accommodating openings 22 into which the diverting inserts 14 can selectively be inserted in such a way that they form the corners of a larger or smaller rectangle on which the wire of the coil is later wound.

Figure 5 shows a particularly clever embodiment of the variation. In this case, one of the diverting organs 14 assumes a fixed position; compare the diverting organ 14, which is in this case attached in the right-hand lower corner.

The position of two further diverting organs 14 can be respectively changed along a line L1 which extends substantially parallel to a side of the coil. For this purpose, the accommodating openings 22a and 22b are provided at the respective places of the winding plate 2 and here each form a row of openings which are disposed one behind the other aligned in said line L1. As can be seen, the openings 22a or 22b are disposed so closely one behind the other that they partially intersect each other.

As can also be seen very well in Fig. 5, the position of the fourth diverting organ 14 can also be changed along another line L2, which, with the two coil sides that meet at this diverting organ, respectively includes an acute angle α or ß, respectively.

If the diverting organs 14 are placed in the outermost accommodating openings 22a and 22b, then a large coil 28 can be wound as it is shown in Fig. 5 with a continuous solid line. If, however, the diverting organs 14 are for example placed in accommodating openings 22a and 22b that are disposed more towards the inside, then a smaller coil 28' can be wound as it is shown in Fig. 5 with a dashed solid line.

Due to the fact that the positions of the diverting organs 14 can be changed only at three instead of four corners, all coils are configured identically in the area in which the ends of the coil lie and the chip connected therewith.

This is advantageous in that the tool can remain unchanged in this area, where it has a complex configuration.

All diverting inserts preferably have a stop 24 with which they rest against the winding plate 2 on the side thereof facing away from the winding groove 18, whereby their plug-in depth is limited.

The diverting inserts moreover have a shaft 23 which is the section of the diverting insert which is accommodated by the winding plate 2 and completely fills its opening. The actual diverting organ 15 protrudes from the end face of the shaft 23 facing towards the winding groove 18. As can best be seen by comparing Figs. 7b and 7c, the respective diverting organ 15 can protrude from the free end face of the shaft 23 of the diverting insert at different portions.

In view of this, it becomes clear that different coils in fine size gradations can be produced without any great effort using a system consisting of a winding plate according to Fig. 8, which comprises the corresponding elongated holes, and diverting organs, which are configured in accordance with what is shown in Figs. 7b and 7c. Thus, using the diverting inserts shown by 7b, for example, the coil 28 can be wound that is shown in Fig. 8 with a black solid line. However, if these diverting inserts are replaced with the diverting inserts shown by Fig. 5, then the smaller coil 28' which is shown by Fig. 8 with a dashed line can readily be wound.

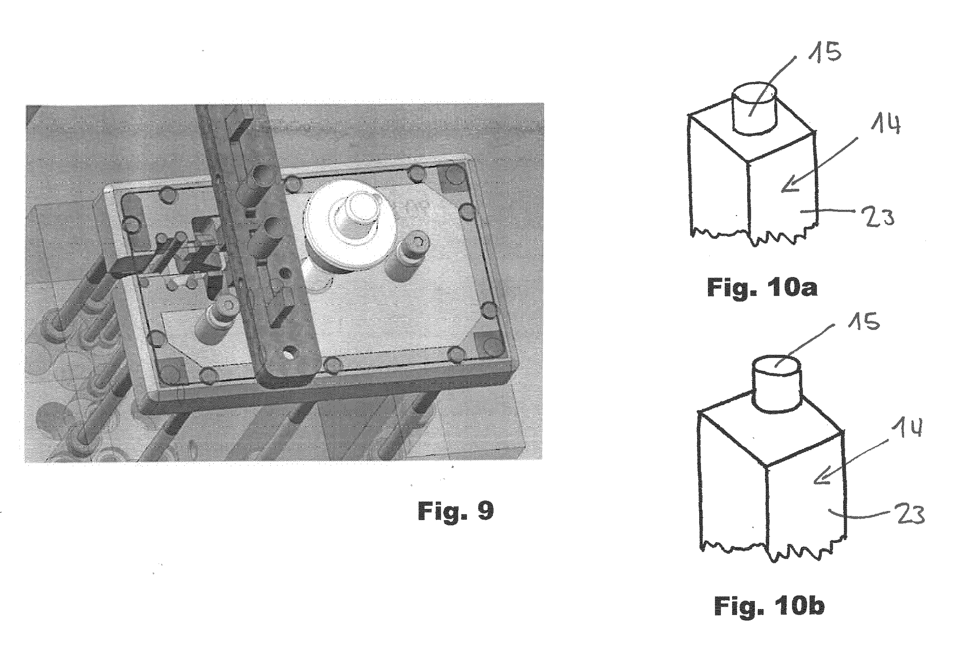

Fig. 9 shows another exemplary embodiment of a winding plate which, together with diverting inserts that are configured in a slightly different way, forms a system for producing coils with different diameters.

The diverting inserts 14 that form a system together with the winding plate 2 according to Figure 9 are characterized in that they have a rectangular or almost square shaft 23 which is considerably larger than the diameter of the diverting organ 15 which protrudes from it on the end face and which projects over the surface of the winding plate 2 facing towards the winding groove 18. This configuration of the diverting inserts 14 permits forming the respective diverting organ 15 at different positions of the end face, in such a way as can be seen clearly when directly comparing Fig. 9 with Figs 10a or 10b. Again, using different diverting inserts, rectangular coils of different sizes can be wound.

Furthermore, Fig. 9 also shows further details, such as the chip ejectors 25 which ensure that the RFID chip 19 does indeed leave the chip accommodating window 5 once the winding plate 2 is lifted off the substrate after the coil has been embedded.

The same purpose is served by the push-off bolts 26 which ensure that the substrate is reliably separated from the winding plate 2 when the winding plate 2 is lifted off the substrate. The push-off bolts 26 ensure a reliable separation between the winding plate 2 and the substrate even if the substrate has locally become stuck to the surface of the winding plate 2 during the embedding of the wire.

Expediently, each of the different above-described diverting organs is respectively configured in such a way that it engages into a bore hole or opening of the bottom part 3 provided therefor and thus ensures an exact positioning of the bottom part 3 relative to the winding plate 2.

Fig. 11 shows the pretreatment device 29 for stripping and/or tin-plating of the ends of the wire 17 forming the coil.

In the exemplary embodiment described here, the pretreatment device for stripping and/or cleaning and/or tin-plating is configured as a multi-arm device whose arms are dimensioned and spaced apart in such a way that the two ends of the wire forming the coil can respectively be stripped, cleaned and/or tin-plated at the same time on several winding devices next to each other, which considerably shortens the required cycle time. In the exemplary embodiment shown by Fig. 11, the multi-arm pretreatment device carries a total of four solder jets for the simultaneous treatment of two winding devices. The solder jets are ideally centrally supplied with solder and inserted into the chip accommodating window 5 from one side in such a way that the wire held taut there is stripped or tin-plated. One or more of the solder jets, which will be explained below, are the preferred means of choice for realizing a pretreatment device.

Within the context of an alternative embodiment, it is provided that the stripping and/or cleaning and/or tin-plating process is not carried out in situ in the winding device, but, relative to the feeding direction of the wire 17 in the direction towards the wire guide, in a station situated upstream.

Figure 12 illustrates the alternative manner of cleaning and/or tin-plating the wire and thus preparing it for soldering or bonding it to the contact surfaces of the chip. In a winding method of the type discussed here, the wire guide 12 that can be advanced in the Z-direction and moved in the X/Y-direction in the substrate plane is fed with wire that is pulled off a wire supply 30, preferably in the form of a spool.

Fig. 12 shows an image of the moment in which the wire laying pin has just finished winding a coil and has pulled the wire forming the second end of the coil across the chip accommodating window 5 and attached it to the winding plate 2. A wire with a free wire length, which at least substantially corresponds to the wire length that is required for producing the subsequent coil, is located between the nozzle of the wire guide 12 and the solder bath, which is in this case configured as a solder jet 27. In the present case, the free wire length from the nozzle of the wire guide 12 to the point A' is preferably at least so large that it corresponds to the wire length required for winding the subsequent coil. In the situation shown by Fig. 12, the solder jet begins acting on the wire at a point A', which in the next coil, which is yet to be laid, corresponds to the point A on the wire of the coil already laid, i.e. to a point which is located preferably up to 30 mm before the position at which the corresponding contact surface of the chip will later come to rest. Then, the wire feed is switched on and the wire is pulled through the solder bath for such a period of time and at such a (mostly reduced) speed until the point E' on the wire is reached which in the coil that is yet to be laid, corresponds to the point E on the wire of the coil already laid. Alternatively, the solder jet can also be moved along the stationary wire. Ideally, the position of the points A' and E' is predetermined with such accuracy that the distance between the points A' and E' is so small that the entire section between these two points can be stripped or tin-plated simply by immersing the stationary wire into the stationary solder jet.

In every one of the aforementioned cases, the wire is stripped, cleaned and optionally tin-plated over the entire distance between the points A' and E'. Once this has happened, the solder jet 27 is retracted and the wire, including the section thereof that has been pretreated as described above, is dispensed via the wire guide 12. What is important is that the distance between the points A' and E' and the absolute position of these points is always calculated in advance in such a way that a first part of the pretreated length (A'E') of the wire later becomes a part of a first coil or a first RFID unit, and a second part of the pretreated length (A'E') of the wire later comes a part of a second coil to be laid subsequent to the first coil. Thus, the division of the wire respectively takes place in the area of the wire length determined by A'E'.

By this procedure, for which protection is sought also, but not only, separately without reference to other parts of the invention, the stripping or decoating of the wire or the cleaning and/or tin-plating of the wire is spatially transferred to a location which is far distant from the location at which the wire ends currently have to be connected to the chip. This is a decisive advantage already because the devices required for stripping/cleaning/tin-plating do not have to be accommodated and operated together with the wire laying pin and the wire gripper in a very confined space.

Figs. 13 and 14 depict the solder jet that is preferably to be used for this method.

Fig. 13 shows an image of the moment in which the solder jet 27, which is formed from an internally fed tube 31 that is preferably shaped in a concave manner at its free end, has just been advanced against the wire in the direction transverse to its longitudinal axis. A little sphere 32 of liquid solder is held at the end of the tube 31 - liquid solder has a high surface tension and therefore does not run. The wire is immersed into this little sphere at this moment. As long as it has not reached the sufficient temperature yet, it cannot be wetted with the solder and therefore pushes the solder sphere back slightly. Once the wire has reached a sufficiently high temperature, the solder wets it as is shown in Fig. 14. If a longer length of wire is to be treated, the wire can now be pushed through the solder sphere and is continuously tin-plated in the process.

It should be noted that protection is separately also sought for the method described above and shown by the Figures 12, 13 and 14, independently from what is recorded in the other claims to which the claims relating to this method refer. For this manner of preparing the wires for connection with the RFID chip by bonding or soldering can also be usefully employed in other methods for producing RFID chips, e.g. for such methods in which the coil is first laid on a substrate in order to then connect the wire ends exclusively to the RFID chip. Accordingly, protection is also sought for a method characterized in that the wire, prior to it being fed into the wire guide used for laying the wire on a substrate or for winding the wire on a winding plate, is stripped or decoated and/or cleaned and/or tin-plated and/or coated with a conductive adhesive or contacting agent in an area which later forms a tail end of one and a front end of a second coil;

### List of Reference Symbols

- 1: Winding unit
- 2: Winding plate
- 3: Bottom part
- 4: Wire feeding channel
- 5: Chip accommodating window
- 6: Middle window
- 7: Wire guide window
- 8: First webs
- 9: Second webs
- 10: Spacer
- 11: Wire gripper
- 12: Wire guide
- 13: Wire clamp
- 14: Diverting insert
- 15: Diverting organ 16 Diverting pin
- 17: Wire
- 18: Winding groove
- 19: RFID-Chip
- 20: Vibrating die
- 21: Substrate
- 22: Accommodating openings
- 22a: Accommodating opening
- 22b: Accommodating opening
- 23: Shaft
- 24: Stop
- 25: Chip ejector
- 26: Push-off bolt
- 27: Solder jet
- 28: Coil
- 29: Pretreatment device for stripping and/or tin-plating
- 30: Wire supply
- 31: Tube of the solder jet
- P1: Arrow
- P2: Arrow
- P3: Arrow
- L1: Line along which a diverting organ 14 can be adjusted
- L2: Line along which a diverting organ 14 can be adjusted
- α: Angle between line L2 and an adjacent lateral edge of the winding plate 2
- β: Angle between line L2 and the other adjacent lateral edge of the winding plate 2

## Claims

1. Method for producing RFID cards with a coil and an RFID chip in which the coil, using a winding device, is first wound as a substrate-less coil, which after the completion of the winding process is held at the end face of a winding plate, whereupon the winding plate is placed against the first side of a substrate with the end face on which it holds the wire wound into a coil, **characterized in that** a vibrating die is placed against the second opposite side of the substrate which transmits such ultrasound vibrations through the substrate into the area of the wire of the coil wedged between the winding plate, which acts as an anvil, and the first substrate surface, that it is embedded at least partially into the substrate surface.

2. Method according to claim 1, **characterized in that** the vibrating die, while substantially permanently applying ultrasound to the substrate, travels, on the second side of the substrate, over the predominant part of the way or preferably the entire way defined by the contact surface along which the wire of the coil rests against the first side of the substrate;

3. Method according to claim 3, **characterized in that** vibrating die also transmits, also through the substrate, vibrations onto the chip or the housing thereof in such a way that the chip or the housing thereof is connected to the substrate.

4. Coil winding and wire laying machine for producing RFID cards with a coil and an RFID chip and at least one the winding plate which, after the completion of the winding process, holds the wire wound into a coil, **characterized in that** the coil winding and wire laying machine comprises a transfer or holding device, which places the winding plate against the first side of a substrate with the end face on which it holds the wire wound into a coil, and a laying device in the form of a vibrating die which presses against the second opposite side of the substrate and which, through the substrate, applies such ultrasound vibrations to the wire of the coil wedged between the winding plate, which acts as an anvil, and the first substrate surface, that it is embedded at least partially into the substrate surface.

5. Coil winding and wire laying machine according to claim 4, comprising a system consisting of a winding plate and diverting inserts inserted into the winding plate, from which diverting organs project, which protrude over the surface of the winding plate, around which the wire is wound into a preferably rectangular coil, **characterized in that** the winding plate is configured in such a way that the position of the diverting organs [define] relative to the winding plate can be changed in such a way that coils can be wound with, in principle, the same course of the wire but different clear diameters.

6. Coil winding and wire laying machine according to claim 5, **characterized in that,** of the four diverting organs forming the outer corners of the rectangular coil, preferably one assumes a fixed position which cannot be changed, whereas the position of two of the diverting organs can be changed along one line, respectively, which substantially extends parallel to a side of the coil, and the position of one diverting organ can be changed along one line which respectively encloses an acute angle with the two sides of the coil that meet at this diverting organ, wherein this acute angle is preferably 45°, respectively.

7. Coil winding and wire laying machine according to claim 6, **characterized in that** the winding plate, on the line along which the position of the respective diverting organ can be changed, has several holes disposed one behind the other for alternatively accommodating the respective diverting insert;

8. Coil winding and wire laying machine according to claim 7, **characterized in that** the winding plate, on the line along which the position of the respective diverting organ can be changed, has a hole, preferably in the form of an elongated hole, whose cross-sectional area is greater than the cross-sectional area of the diverting organ associated with it, wherein it is preferably an elongated hole, wherein the hole is capable of accommodating different alternative diverting inserts that are part of the system, i.e. diverting inserts that comprise a shaft which fills the hole and from whose end face a diverting organ protrudes at different positions.

9. Coil winding and wire laying machine according to claim 8, **characterized in that** the diverting organs are stepped in such a way that they hold several wires, each of which form one coil winding, one above the other in the vertical direction and one next to the other in the horizontal direction.
